# EUROPEAN PATENT SPECIFICATION

(11) **EP 1 507 267 B1**
(45) Date of publication and mention of the grant of the patent: **05.11.2008**
(21) Application number: 03752892.4
(22) Date of filing: 14.04.2003
(51) Int. Cl.: H01B 1/02, H01B 5/14, C22C 5/06, C22C 9/00, H01L 29/786, H01L 21/28, G02F 1/1343

(54) **WIRING MATERIAL AND WIRING BOARD USING THE SAME**
VERDRAHTUNGSMATERIAL UND VERDRAHTUNGSBOARD DAMIT
MATERIAU DE CABLAGE ET TABLEAU DE CONNEXIONS METTANT EN OEUVRE CE MATERIAU

(30) Priority: 17.05.2002 JP 2002143312; 17.05.2002 JP 2002143318
(43) Date of publication of application: 16.02.2005
(60) Divisional application: 08163123.6
(73) Proprietor: IDEMITSU KOSAN COMPANY LIMITED, Tokyo 100-0005 (JP)
(72) Inventor: INOUE, Kazuyoshi, Sodegaura-shi, Chiba 299-0205 (JP)
(74) Representative: Gille Hrabal Struck Neidlein Prop Roos
(86) International application number: PCT/JP2003/004690
(87) International publication number: WO 2003/098641

(56) References cited:
- JP-A- 11 097 609
- JP-A- 52 049 916
- JP-A- 55 154 541
- JP-A- 58 133 339
- JP-A- 60 026 625
- JP-A- 61 037 937
- JP-A- 61 130 449
- JP-A- 2001 102 592
- JP-A- 2001 192 752
- JP-A- 2001 196 371
- JP-A- 2001 342 560
- US-A- 4 290 806
- US-A- 4 732 731
- PATENT ABSTRACTS OF JAPAN vol. 007, no. 242 (C-192), 27 October 1983 (1983-10-27) & JP 58 133339 A (MATSUSHITA DENKO KK), 9 August 1983 (1983-08-09)
- PATENT ABSTRACTS OF JAPAN vol. 010, no. 321 (C-382), 31 October 1986 (1986-10-31) & JP 61 130449 A (TANAKA KIKINZOKU KOGYO KK), 18 June 1986 (1986-06-18)
- PATENT ABSTRACTS OF JAPAN vol. 009, no. 145 (C-287), 20 June 1985 (1985-06-20) & JP 60 026625 A (TANAKA KIKINZOKU KOGYO KK), 9 February 1985 (1985-02-09)
- PATENT ABSTRACTS OF JAPAN vol. 001, no. 091 (C-023), 24 August 1977 (1977-08-24) & JP 52 049916 A (MITSUBISHI MARORII YAKIN KOGYO KK), 21 April 1977 (1977-04-21)
- PATENT ABSTRACTS OF JAPAN vol. 014, no. 314 (C-0737), 5 July 1990 (1990-07-05) & JP 02 107732 A (DOWA MINING CO LTD), 19 April 1990 (1990-04-19)

## Description

### TECHNICAL FIELD

The present invention relates to wiring materials and reflective electrodes for use in TFT liquid crystal displays (TFT-LCDs) or organic electroluminescence devices, and a manufacturing method thereof.

### BACKGROUND ART

Thin-film transistor (TFT) liquid crystal displays (which are referred to simply as TFT-LCDs, hereinafter) have distinctive features, such as high display performance and superior energy efficiency, and have thus become mainstream displays used in portable personal computers, laptop computers, TVs, and other display systems. While different manufacturers offer different methods for producing TFT-LCDs, each method involves many steps and requires deposition of various metals and metal oxides. Thus, there is a need to reduce the number of production steps involved.

TFTs are also used to drive organic electroluminescence (EL) displays, another type of display devices.

### Basic structure of TFT-LCDs

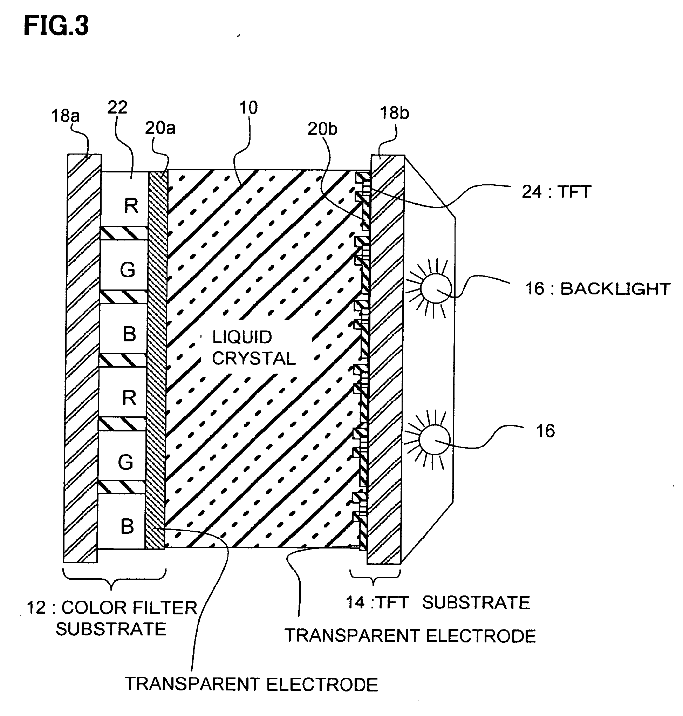

The basic structure of conventional TFT-LCDs is first described. Referring to Fig. 3, a transmissive TFT-LCD is shown in a schematic cross-section. As shown, the transmissive TFT-LCD has a basic structure in which a liquid crystal 10 is sandwiched between a color filter substrate 12 and a TFT substrate 14. A backlight 16 is placed behind the TFT substrate 14 to illuminate the transmissive TFT-LCD from behind.

The color filter substrate 12 has a structure in which a color filter 22 is sandwiched between a glass substrate 18a and a transparent electrode 20. The color filter substrate 12 transmits red (R), green (G), and blue (B) light.

The TFT substrate 14 includes a transparent electrode 20b disposed on a glass substrate 18b. Signal voltages are applied to the transparent electrode 20 via a TFT 24.

In the construction shown in Fig. 3, a single polarizer is arranged on one face of the color filter substrate 12 and another polarizer on one face of the TFT substrate 14. Such a construction is well known in the art.

Unlike the transmissive TFT-LCD of Fig. 3, a reflective TFT-LCD has a construction in which the TFT substrate 14 includes, rather than the transparent electrode 20b, a reflective electrode made of aluminum or a similar reflective material. Since the reflective TFT-LCD reflects incoming light, it does not require the backlight 16.

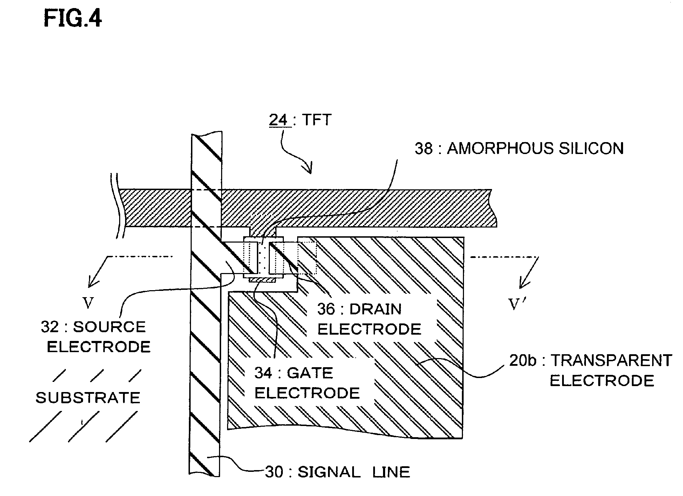

Referring now to Fig. 4, the basic structure of a single pixel on the TFT substrate 14 of the transmissive TFT-LCD is shown in a schematic plan view. As shown, data on a signal line 30 is applied to the transparent electrode 20b via switching by a TFT 24. The TFT 24 includes a source electrode 32, a gate electrode 34 and a drain electrode 36. An amorphous silicon 38 and other materials are deposited in the region of the gate electrode 34.

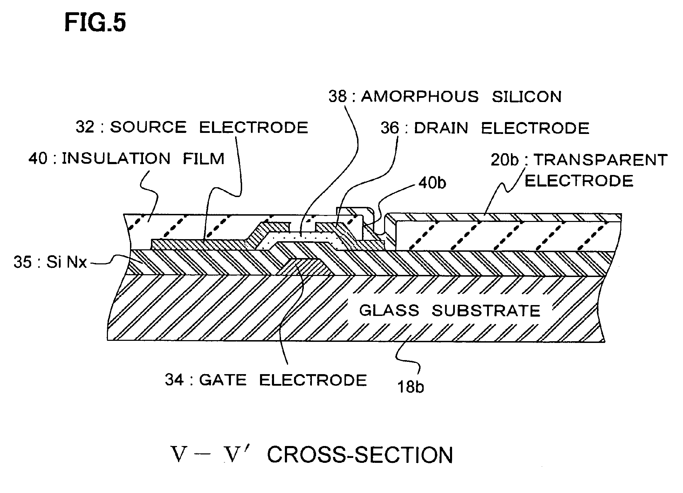

Referring to Fig. 5, which is a schematic cross-section taken along the line V-V' of Fig. 4, the gate electrode 34 is disposed on the glass substrate 18b and is overlaid with an SᵢNₓ film 35. Also disposed above the gate electrode 34 is the layer of amorphous silicon 38.

The source electrode 32 and the drain electrode 36 are arranged on opposite ends of the amorphous silicone 38, each partially overlapping the gate electrode. These components are entirely overlaid with an insulation film 40. The transparent electrode 20b is disposed over the insulation film 40 and is electrically connected to the drain electrode 36 via a through hole 40b formed in the insulation film 40.

### Wiring used in TFT-LCDs

In the production of TFT arrays for driving conventional TFT-LCDs, the possibility of using such metals as Cr, TaW, and MoW in the gate electrodes or the source/drain electrodes has been examined.

Of these metals, Cr is readily workable but is susceptible to corrosion, whereas TaW and MoW are relatively resistant to corrosion but have a large electrical resistance.

Thus, workable metals with low electrical resistance have been widely used. When we simply say "metals with low electrical resistance," what comes first to mind are such metals as Ag, Cu, and Al. For this reason, TFT arrays (transistor arrays) using aluminum-based wiring have been proposed conventionally. It has been known that aluminum may cause formation of protrusions known as "hillocks" on the surface of electrodes. When formed on electrodes such as the source electrodes of a TFT, the hillocks may penetrate the overlaying insulation layer and come into contact with the top transparent electrode, resulting in defective products. Thus, Nd has been added to aluminum to prevent formation of such hillocks.

When such an aluminum electrode directly comes into contact with the silicon layer and the transparent electrode, however, aluminum may diffuse into the silicon layer, causing a decrease in the device performance or oxidation of aluminum into alumina, which quite likely results in an increase in the electrical resistance between the transparent electrode and the TFT. As a result, the components of the TFT array may fail.

The addition of Nd to aluminum may also lead to a high electrical resistance comparable to that of TaW and MoW.

For these reasons, one conventional, improved approach employs a structure in which the aluminum electrode is sandwiched by Mo or Ti to minimize the contact resistance with the oxide-made transparent electrode. Specifically, Mo is first deposited over the silicon layer and the aluminum layer is then formed on top of the Mo film to prevent diffusion of aluminum into the silicon layer. Another Mo layer is then deposited over the aluminum layer to prevent the increase in the contact resistance with the transparent electrode due to oxidation. In brief, the conventional TFT-LCDs employ the three-layered wirings of Mo/Al/Mo. Three-layered wirings of Ti/Al/Ti are also employed for the same reason.

### Conventional Examples of Ag Alloys

Japanese Patent No. 1297072 describes one example in which an Ag-based alloy is used as a material to form electrical contacts. The patent discloses the use of an Ag alloy containing 5 to 20wt% of one or two of Fe, Co, and Ni. Ag alloys of other compositions are also described. Also, Japanese Patent No. 1585932 describes an Ag alloy containing Ni and Zr in amounts of 5 to 25wt% and 0.05 to 8wt%, respectively.

Japanese Patent Laid-Open Publication No. 2001-192752 describes one example in which an Ag-based alloy is used as a metal material for various electronic parts. The Ag alloy described in this publication contains 0.1 to 3wt% of Pd along with total of 0.1 to 3wt% of Au, Pt, Cu, Ta, Cr, Ti, Ni, Co, Si, or other metals.

Japanese Patent Laid-Open Publication No. 2001-102592 describes one example in which a particular Ag-based alloy is used in gate electrodes. Aside from Ag to serve as the major component, this alloy contains Pd and one or more metals selected from Zn, Co, Fe, Cr, Mn, and Ti.

### Conventional Examples of Cu Alloys

Japanese Patent No. 1549371 (Japanese Patent Application No. Sho 57-6061) describes the use of a copper alloy as a material for lead wires used in various semiconductor instruments. Aside from Cu to serve as the major component, the copper alloy described in this patent contains 0.4 to 4wt% of Ni and 0.1 to 1wt% of Si. It also contains P and As as minor components.

Japanese Patent No. 1914484 (Japanese Patent Application No. Sho 58-65265) describes particular Cu alloys, each containing Cu as the major component. Among the Cu alloys described are one containing 0.01 to 2.0wt% of Cr, one containing 0.005 to 1.0wt% of Zr, and one containing both Cr and Zr.

Also, Japanese Patent No. 2136017 (Japanese Patent Application No. Sho 62-124365) describes one example of copper alloys for use in semiconductors. The copper alloy described in this patent contains 1.0 to 4.0wt% of Ni, 0.2 to 1.0wt% of Si, 0.0005 to 0.5% of Ag, and 2.0wt% or less of Zn, Mn, Co and/or other metals.

### Conventional Examples of the Use of Copper in Electrodes for Displays

Japanese Patent No. 2579106 (Japanese Patent Laid-Open Publication No. Hei 05-188401) mentions a Cr/Cu/Cr three-layered structure of gate electrodes for TFT (thin-film) transistors used in TFT-LCD panels. In addition, Japanese Patent Laid-Open Publication No. Hei 10-153788 mentions a construction of gate electrodes for use in liquid crystal displays. This gate electrode consists of an alloy of Cu and Zr, and a ZrO oxide layer disposed over the alloy. Furthermore, Japanese Patent Laid-Open Publication No. 2001-196371 mentions a layered structure of conductive metals comprising copper thin film patterns and IZO thin film patterns. Moreover, Japanese Patent Laid-Open Publication No. 2001-223217 describes a thin film of a metal oxide conductor having a contact resistance with a copper thin film of 1.0x10⁻⁶ Ω·cm or less.

### DISCLOSURE OF THE INVENTION

As described above, formation of the three-layered wiring requires sandwiching the aluminum electrode, which involves complex processes of initial deposition of Mo or Ti, followed by deposition of aluminum-based metal, and then another deposition of Mo or Ti.

As described above, examples of metals other than aluminum having low electrical resistance include Ag and Cu. Thus, attempts have been made to address the aforementioned problems by using Ag and Cu electrodes. Ag and Cu, however, have poor adhesion to glass substrates and silicon films and readily come off during the production process.

The present invention has been made in view of the above-described problems with a principal objective of providing a wiring material using a particular alloy that contains Ag as a major component (*i*.*e*., Ag alloy) and offers improved adhesion to glass substrates and silicon films.

It is a second objective of the present invention to provide a wiring material using a particular alloy that contains Cu as a major component (*i*.*e*., Cu alloy) and offers improved adhesion to glass substrates and silicon films.

### 1. The invention regarding Ag alloy

In an effort to find a way to address the aforementioned problems, the present inventors have found that these problems can be overcome by using a wiring made of an Ag alloy that contains Ag and Zr as essential components and further contains at least one metal selected from the group consisting of Au, Ni, Co and Al.

It has proven that such an Ag alloy wiring shows a good adhesion to glass substrates, has a low electrical resistance, and allows little or no metal atoms to diffuse into the silicon layer even when the wiring comes into direct contact with the silicon layer. This Ag alloy wiring thus causes little or no decrease in the performance of the components of a TFT array.

It has also proven that even when an electrode (transparent electrode) for driving liquid crystal displays that contains indium oxide, tin oxide, or zinc oxide as a major component is formed directly over the Ag alloy metal electrode, the contact resistance between the metal electrode and the transparent electrode will not become excessively large and the device will operate stably.

The Ag alloy is preferably deposited by sputtering.

The target used contains Ag and Zr as essential components. Specifically, the target has a composition adjusted in such a manner that the resulting thin film contains 60 to 99wt% of Ag, 1 to 5wt% of Zr, 0 to 20wt% of each of Au, Ni and Co, and 0 to 39% of Al. In general, the target used in the sputtering has the same composition as the desired film. In this manner, the resulting film has a desired composition.

By adjusting the composition, compounds such as AgZr₂ and AgZr are produced. As a result, the dispersibility of Zr is improved, leading to generation of NiZr, NiZr₂ and Ni₃Zr, and AuZr₂ and Au₂Zr. This facilitates the dispersion of the third component to ensure stable sputtering.

The Ag alloy metal electrode has a high adhesion to glass substrates and silicon films, does not come off during the production process, and can thus be manufactured in a stable manner.

Specific constructions of this aspect of the present invention are as follows:

### 1-A The invention regarding the wiring material

Intended to overcome the above-described problems, the present invention provides a wiring material made of an Ag alloy that contains Ag and Zr as essential components and further contains at least one metal selected from the group consisting of Au, Ni, Co, and Al. Such an Ag alloy shows an improved adhesion to glass substrates and silicon wafers.

Also, the present invention is the wiring material, wherein the above-described Ag alloy contains 60 to 99wt% of Ag and 1 to 5wt% of Zr.

If the amount of Zr is 1wt% or less, then the desired effect is not obtained and the adhesion strength to a silicon wafer remains low. In comparison, if Zr is present in excessive amounts, then the resistance (specific resistance) of the film made of the wiring material becomes large, sometimes exceeding 4 Ω·cm, and an increased occurrence of abnormal discharge is observed during sputtering. Thus, if present in any amount outside the range of 1 to 5wt%, Zr may impart to the wiring material undesired properties for low resistance wirings.

The Ag alloy described in the first paragraph of this section for use in the wiring material contains 60 to 99wt% of Ag, 1 to 5wt% of Zr, 0 to 20wt% of Au, 0 to 20wt% of Ni, 0 to 20wt% of Co, and 0 to 39wt% of Al.

It was observed that the addition of Au, Ni, and Co increases the strength of the adhesion to a glass surface. Nonetheless, if any of these components are present in amounts exceeding 20wt%, the consequences will be an increase in cost for Au, and an increased resistance (specific resistance) greater than 4 µΩ·cm and an increased occurrence of abnormal discharge during sputtering for Ni. Thus, if present in any amount exceeding 20wt%, each of Au, Ni and Co may impart to the wiring material undesired properties for low resistance wirings.

While Au, Ni, and Co have been described, it should be appreciated that each of these third metals must be of the type that does not diffuse into the semiconductor layer or of the type that does not affect the performance of the semiconductor devices even when it diffuses into the semiconductor layer, or each must be added in amounts that do not affect the performance of the semiconductor devices.

Examples of the Ag/Zr alloys include AgZr₂ and AgZr. Examples of the Zr/Ni alloys include NiZr, NiZr₂, and Ni₃Zr. Examples of the Zr/Au alloys include AuZr₂, Au₂Zr, AuZr₃, and Au₄Zr.

The wiring material according to the present invention may further contain 0 to 1wt% of at least one metal selected from the group consisting of Re, Ru, Pd, and Ir.

The wiring material according to the present invention preferably has a specific resistance of 4 µΩ·cm or less.

When used in thin films to serve as wirings of semiconductor devices, the material with 4 µΩ·cm or a larger specific resistance will cause delayed signals of non-negligible magnitude. Thus, it is preferred to obtain, by using wiring materials with 4 Ω·cm or smaller specific resistance, thin films for wirings that cause less delayed signals.

### 1-B The invention regarding the wiring boards

The present invention also provides a wiring board comprising a substrate, and wirings formed on the substrate and made of the wiring material having the above-described composition.

According to the present invention, the substrate used in the wiring board is preferably a glass substrate or a silicon substrate. As described, the wiring material of the present invention has strong adhesion to glass substrates and silicon wafers and can thus be used to make wirings that do not readily come off the substrate.

When tested for the adhesion strength of the wiring to the substrate, the wiring board according to the present invention gives an adhesion of 3N or higher. If this adhesion is lower than 3N, the wiring may come off the substrate during the production process.

Preferably, the wirings of the wiring board according to the present invention are formed on a substrate as a gate wiring or a gate electrode of a thin film transistor. In such a case, the present invention serves as "semiconductor device wiring board." Such constructions make it possible to minimize the resistance of the gate electrodes of thin film transistors and thus helps improve the performance of thin film transistors.

The wirings of the wiring board according to the present invention are preferably formed on a substrate as a source wiring and a drain wiring or a source electrode and a drain electrode of thin film transistors. Also in this case, the present invention serves as a semiconductor device wiring board. This construction makes it possible to minimize the resistance of the source and gate electrodes of thin film transistors and thus helps improve the performance of thin film transistors.

Preferably, the wiring board of the present invention is non-conductive at least on its surface and includes a conductive metal oxide layer deposited over the wirings.

Preferably, the wirings and the metal oxide layer of the wiring board of the present invention form a stacked wiring of a two-layered structure.

The conductive metal oxide film for use in the present invention may be a transparent electrode such as IZO (registered trademark).

Such a construction can be used to minimize the resistance of electrodes of reflective LCDs or organic EL devices and helps improve the performance of thin film transistors and, thus, the performance of reflective LCDs and organic EL devices.

According to the present invention, the conductive metal oxide film may comprise an amorphous transparent conductive film that is formed of indium oxide and zinc oxide and has an atomic composition such that the following relationship holds: In/(In+Zn) = 0.8 to 0.95. If this value is less than 0.8, then the resistance of the metal oxide thin film may become excessively large, whereas if the value is greater than 0.95, the etching rate may be decreased.

According to the present invention, the amorphous transparent conductive film has a work function of 5.4 eV or larger. When the wiring board of the present invention is used to construct an organic EL device, work functions of 5.4 eV or larger are preferred in order to enhance hole injection.

### 2. The invention regarding Cu alloys

In an effort to find a way to address the aforementioned problems, the present inventors have found that these problems can be overcome by using a particular Cu alloy in the wirings. Specifically, this Cu alloy contains Cu, the major component, in an amount of 80 to 99.5% and further contains Au and Co in a total amount of 0.5 to 20wt%.

It has been proven that this Cu alloy wiring has high adhesion to glass substrates, has a low resistance, and hardly diffuses into the silicon layer even when the wiring comes in direct contact with the silicone layer. This Cu alloy wiring thus causes little or no decrease in the performance of the components of a TFT array.

It has also been proven that even when an electrode (transparent electrode) for driving liquid crystal displays that contains indium oxide, tin oxide, or zinc oxide as a major component is formed directly over the Cu alloy metal electrode, the contact resistance between the metal electrode and the transparent electrode will not become excessively large and the device can operate stably.

The Cu alloy is preferably deposited by sputtering.

The target used contains Au and Co and contains Cu as the major component. Specifically, the target has a composition adjusted in such a manner that the resulting film contains 80 to 99.5wt% of Cu and 0.5 to 20wt% of Au and Co. In general, the target used in the sputtering has the same composition as the desired film. In this manner, the resulting film has a desired composition.

The target made of such compounds as CuAu and Cu₃Au facilitates not only the dispersion of Cu, but also the dispersion of the other components. As a result, the sputtering process is stabilized.

This Cu alloy metal electrode has high adhesion to glass substrates and silicon films, does not come off during the production process, and can thus be manufactured in a stable manner.

Specific constructions of this aspect of the present invention will now be described, starting from the invention regarding the wiring material.

### 2-A The invention regarding the wiring material

Intended to overcome the above-described problems, the present invention provides a wiring material made of a Cu alloy that is composed of Cu, along with Au and Co, and contains Cu in an amount of 80 to 99.5wt% and Au and Cu in a total amount of 0.5 to 20wt%.

Such a Cu alloy shows an improved adhesion to glass substrates and silicon wafers.

More preferably, the wiring material contains up to 10wt% of Au and up to 10wt% of Co.

Experiments conducted by the present inventors revealed the following facts concerning the amounts of Au and Co: Au and Co cannot provide the desired effects if the total amount of the two components is 0.5% or less. In such a case, the wiring material has low adhesion to a glass surface.

Also, if the total amount of these components exceeds 20wt%, the consequences will be an increase in cost (for Au), and an increased resistance (specific resistance) and an increased occurrence of abnormal discharge during sputtering (for Co). Thus, if present in a total amount of greater than 20wt%, Au and Co may impart to the wiring material undesired properties for low resistance wirings.

While Au and Co have been described, it should be appreciated that each of these third metals must be of the type that does not diffuse into the semiconductor layer or of the type that does not affect the performance of the semiconductor devices even when it diffuses into the semiconductor layer, or each must be added in amounts that does not affect the performance of the semiconductor devices.

The wiring material according to the present invention preferably has a specific resistance of 4 µΩ·cm or less.

When used in thin film to serve as wirings of semiconductor devices, the material with 4 µΩ·cm or larger specific resistance will cause delayed signals of non-negligible magnitude. Thus, it is preferred to obtain, by using wiring materials with 4 µΩ·cm or smaller specific resistance, thin films for wirings that cause less delayed signals.

The invention regarding a wiring board using the above-described wiring material will now be described.

### 2-B The invention regarding the wiring boards

The present invention also provides a wiring board comprising wirings formed of the above-described wiring material, a conductive metal oxide film, and a substrate. Preferably, the wirings and the metal oxide layer in the present invention form a stacked wiring of a two-layered structure.

The conductive metal oxide film for use in the present invention may be a transparent electrode such as IZO, which is a registered trademark.

Such a construction can be used to minimize the resistance of electrodes of reflective LCDs or organic EL devices and helps improve the performance of thin film transistors and, thus, the performance of reflective LCDs and organic EL devices.

Preferably, the wiring board of the present invention contains at least one metal selected from the group consisting of Ru, Pd, Re, and Ir. This metal is contained in an amount of 0.05 atomic percent to 5 atomic percent.

When contained in amounts less than 0.05 atomic percent, the metal may not provide the desired effects and its work function may not reach 5.4 eV. In comparison, the metal present in amounts greater than 5 atomic percent may result in a decreased etchability and may cause unexpected coloring.

While the preferred range is specified as 0.05 to 5 atomic percent in the present invention, it is more preferred that the metal is contained in an amount of approximately 3 atomic percent: an example will be described later in which 3 atomic percent of the metal is contained.

According to the present invention, the conductive metal oxide film may comprise an amorphous transparent conductive film that is formed of indium oxide and zinc oxide and has an atomic composition such that the following relationship holds: In/(In+Zn) = 0.8 to 0.95. If this value is less than 0.8, then the resistance of the metal oxide thin film may become excessively large, whereas if the value is greater than 0.95, the etching rate may be decreased.

Preferably, the substrate for use in the wiring board of the present invention is non-conductive on its surface. Preferably, the wiring board according to the present invention comprises a wiring formed on the substrate and a thin film transistor.

Such constructions make it possible to minimize the resistance of the electrodes and wirings of thin film transistors and thus helps improve the performance of thin film transistors.

### BRIEF DESCRIPTION OF THE DRAWINGS

Fig. 1 is a table showing different properties of wiring materials according to the present embodiment.

Fig. 2 is a table showing different properties of wiring materials of the present embodiment.

Fig. 3 is a schematic cross-section of a transmissive TFT-LCD.

Fig. 4 is a schematic plan view showing the basic structure of a single pixel of a transmissive TFT-LCD.

Fig. 5 is a schematic cross-section taken along the line V-V' of Fig. 4.

### BEST MODE FOR CARRYING OUT THE INVENTION

Preferred embodiments of the present invention will now be described with reference to the accompanying drawings.

### 1. An embodiment of Ag alloy

In this embodiment, an Ag alloy is proposed to serve as a wiring material according to the present invention. This alloy contains Ag as the major component and shows good adhesion to glass substrates and silicon wafers.

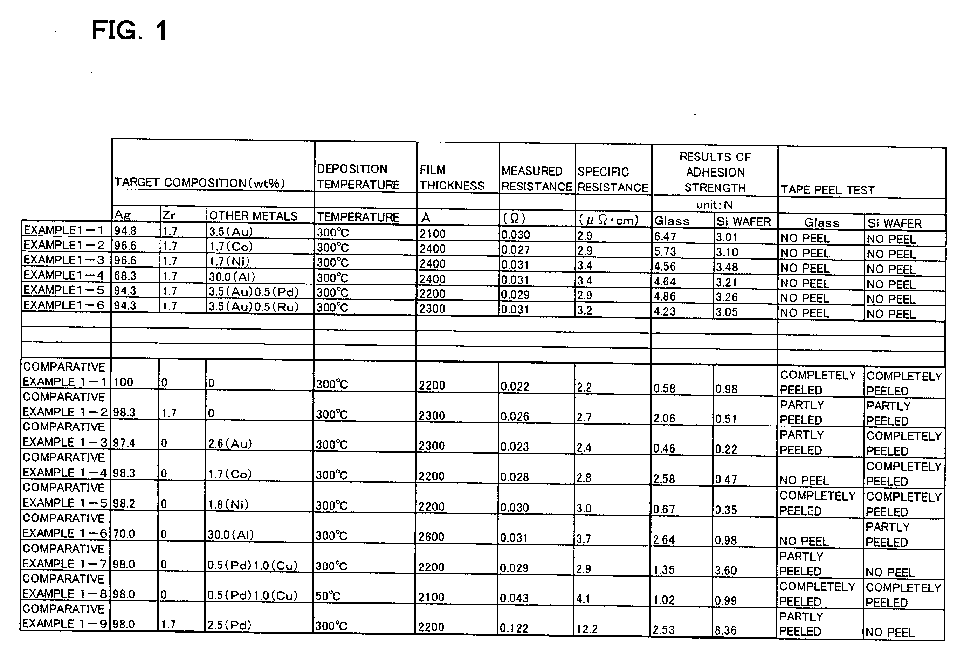

In particular, one example is described in which such an alloy is produced by sputtering. First, we briefly describe the preparation of a target used in the sputtering process. At a predetermined ratio, Zr, along with Ni, Mo, or Au, is mixed with Ag and melted in a vacuum smelting furnace. The melt is allowed to cool and harden and the hardened alloy is rolled into a plate, which in turn is cut and abraded to form a target measuring 4 inches in diameter. For sputtering, the target is mounted on a backing plate of a sputtering apparatus. By the time the sputtering process using this target is finished, a film has been deposited on a glass surface or a silicon wafer. The performances of thin films having different compositions are compared with one another. The results of the comparison are shown in the table in Fig. 1, which contains the compositions used, conductivities of the thin films and other data.

The composition of each film was determined by an X-ray microanalyzer (EPMA: Electron Probe Micro-Analysis), and the conductivity of each film was determined by the four probe technique.

Each film was measured for the peel strength in the scratch test and tape peel test. The apparatus used for the scratch test was Micro-Scratch Tester (CSME). The peel strength was determined under the following conditions.
Scratch distance: 20 mm
Scratch load: 0 to 10 N
Load rate: 10 N/min
Scratch speed: 20 mm/min
Shape of diamond cone: 200 µm in diameter
After the scratch test using the above conditions, the sample was observed with a light microscope and the distance between the point where the glass substrate (wafer) or silicon was exposed (peel point) and the starting point of scratching was measured to determine the peel load.

In the tape peel test, a 1mm-pitch grid is cut on the thin film with a knife, and a strip of an adhesive tape is applied to the film. The tape is then peeled and the degree of peeling of the film is determined as a measure of adhesion.

The scratch test and the tape peel test were performed according to standards defined by Japanese Industrial Standards (JIS).

The table in Fig. 1 shows six examples in which different alloys, formed by adding Zr, Au, Co, Ni, and other metals to Ag, were used as the target in sputtering to deposit a film on a glass substrate and a silicon wafer.

In Example 1-2, Co was added to (Ag + Zr) to form the target. In Example 1-3, Ni was added to (Ag + Zr), while Al is added to (Ag + Zr) in Example 1-4. In Example 1-5, Pd was added to the composition where Au was added to (Ag + Zr) shown in Example 1-1. In Example 1-6, Ru was added to the composition where Au was added to (Ag + Zr) shown in Example 1-1.

In each example, the adhesion strength of 3 N or greater was achieved. In each example, no peeling was observed on the glass substrate or silicon wafer in the tape peel test.

In Comparative Example 1-1, Ag was used alone. In this example, the adhesion strength was 1 N or less and peeling was observed on each of the glass substrate and the silicon wafer.

Comparative Examples 1-2 through 1-8 did not use Zr. Peeling was observed on the glass substrate and the silicon wafer in each of these examples.

Comparative Example 1-9, in which Pd was added to Comparative Example 1-2, showed a large specific resistance and thus did not achieve the objective of the invention. In addition, peeling was observed on the glass substrate.

### [Example 1-1]

This example is for reference and comprises a transmissive TFT-LCD in which an exemplary Ag alloy of the present invention is used in the wiring. While the basic structure of transmissive TFT-LCD has already been described with reference to Figs. 3 to 5, various protective films/layers (not shown in Figs. 3 to 5) are formed in actual production processes.

First, an Ag alloy containing 1.7wt% Zr and 3.5wt% Au is deposited on a transparent glass substrate 18b to a film thickness of 1500 angstroms (specific resistance = 2.8 µΩ·cm) by using the high frequency sputtering technique. The process is performed at room temperature. The resulting film is subjected to a photo-etching process using an aqueous etching solution containing nitric acid, acetic acid, and phosphoric acid to form a gate electrode 34 and wirings for the gate electrode of desired shape.

Next, using the glow discharge CVD technique, a silicon nitride (SiNₓ) film to serve as the gate insulation film is deposited to a film thickness of 3000 angstroms. This is followed by the deposition of α-Si:H(i) film 38 to a film thickness of 3500 angstroms. As the discharge gas, an SiH₄-NH₃-N₂ gas and an SiH₄-N₂-based mixed gas are used for the deposition of the SiNₓ film 35 and the α-Si:H(i) film 38, respectively. The SiNₓ film 35 is subjected to dry etching using CF₄ gas to form a desired protective layer for the channels.

Using an SiH₄-H₂-PH₃-based mixed gas, an α-Si:H(n) film is then deposited to a film thickness of 3000 angstroms. Subsequently, an Ag alloy containing 1.7wt% Zr and 1.7wt% Ni is deposited over the α-Si:H(n) film to a film thickness of 0.3 µm (specific resistance = 3.4 µΩ·cm) using the sputtering technique. The process is performed at room temperature.

This layer is then subjected to a photo-etching process using an aqueous etching solution containing nitric acid, acetic acid, and phosphoric acid to form a desired pattern of a source electrode 32 and a drain electrode 36. Subsequently, the α-Si:H(i) film 38 and the α-Si:H(n) film are each etched into a desired pattern using dry etching with CF₄ gas in conjunction with wet etching with an aqueous solution of hydrazine (NH₂NH₂·H₂O). Using the glow discharge CVD technique, a silicon nitride (SiNₓ) film to serve as the gate insulation film is then deposited to a film thickness of 3000 angstroms. As the discharge gas, an SiH₄-NH₃-N₂ gas is used for the deposition of the SiNₓ film. The SiNₓ film is then subjected to a photo-etching process by dry etching using CF₄ gas to form an output port for the gate electrode 34, an output port for the source electrode 32, and a through hole 40b to provide electrical connection between the drain electrode 36 and the transparent electrode 20b. The Ag alloy electrode so obtained is then exposed to argon plasma to clean the surface.

Subsequently, an amorphous transparent conductive film composed mainly of indium oxide and zinc oxide is deposited using the sputtering technique. The target used for the sputtering process is a sintered body of In₂O₃-ZnO in which the atomic ratio of In/(In+Zn) has been adjusted to 0.83. This sintered body is mounted on the cathode of a planar magnetron sputtering apparatus so that it can serve as the target. Using a pure argon gas or an argon gas containing approximately 1vol% oxygen as the discharge gas, a film for transparent electrode 20b is deposited to a film thickness of 1200 angstroms. The X-ray diffraction analysis of the resulting In₂O₃-ZnO film showed no peaks, indicating that the film was amorphous.

The resulting film for transparent electrode 20b was subjected to a photo-etching process using a 3.4wt% aqueous solution of oxalic acid to form a desired pattern for pixel electrodes and output electrodes. A black matrix pattern is then formed to complete an α-SiTFT substrate 14. This TFT substrate 14 was used to make a TFT-LCD flat display. Video signals were provided to the display to confirm that the display had good performance.

### [Example 1-2]

This example comprises a reflective TFT-LCD in which an exemplary Ag alloy of the present invention is used in the wiring. The basic structure of reflective TFT-LCD is different from that of the transmissive TFT-LCD in that a light reflective electrode is used in place of the transparent electrode 20b on the TFT substrate 14 of the transmissive TFT-LCD. While not shown in Figs. 3 to 5, various protective films/layers are deposited in actual production processes. It is well known that reflective TFT-LCDs are different from transmissive TFT-LCDs in many ways, aside from the electrodes.

First, an Ag alloy containing 1.7wt% Zr and 3.5wt% Au is deposited on a transparent glass substrate 18b to a film thickness of 1500 angstroms (specific resistance = 2.8 µΩ·cm) by using the high frequency sputtering technique. The process is performed at room temperature. The resulting film is subjected to a photo-etching process using an aqueous etching solution containing nitric acid, acetic acid, and phosphoric acid to form a gate electrode 34 and wirings for the gate electrode of desired shape.

Next, using the glow discharge CVD technique, a silicon nitride (SiNₓ) film to serve as the gate insulation film is deposited to a film thickness of 3000 angstroms. This is followed by the deposition of α-Si:H(i) film 38 to a film thickness of 3500 angstroms. As the discharge gas, an SiH₄-NH₃-N₂ gas and an SiH₄-N₂-based mixed gas are used for the deposition of the SiNₓ film 35 and the α-Si:H(i) film 38, respectively. The SiNₓ film 35 is subjected to dry etching using CF₄ gas to form a desired protective layer for the channels.

Using an SiH₄-H₂-PH₃-based mixed gas, an α-Si:H(n) film is then deposited to a film thickness of 3000 angstroms. Subsequently, an Ag alloy containing 1.7wt% Zr and 1.7wt% Ni is deposited over the α-Si:H(n) film to a film thickness of 0.3 µm (specific resistance = 3.4 µΩ·cm) using the sputtering technique. The process is performed at room temperature.

Subsequently, an amorphous transparent conductive film composed mainly of indium oxide and zinc oxide is deposited using the sputtering technique.

This layer is then subjected to a photo-etching process using an aqueous etching solution containing nitric acid, acetic acid, and phosphoric acid to form a desired pattern of a source electrode 32 and a drain electrode 36. Subsequently, the α-Si:H(i) film 38 and the α-Si:H(n) film are each etched into a desired pattern using dry etching with CF₄ gas in conjunction with wet etching with hydrazine (NH₂NH₂·H₂O). Using the glow discharge CVD technique, a silicon nitride (SiNₓ) film to serve as the gate insulation film is then deposited to a film thickness of 3000 angstroms. As the discharge gas, an SiH₄-NH₃-N₂ gas is used for the deposition of the SiNₓ film. The SiNₓ film is then subjected to a photo-etching process by dry etching using CF₄ gas to form an output port for the gate electrode 34, an output port for the source electrode 32, and a through hole 40b to provide electrical connection between the drain electrode 36 and the transparent electrode 20b. The Ag alloy electrode so obtained is then exposed to argon plasma to clean the surface.

Subsequently, an Ag alloy containing 1.7wt% Zr and 3.5wt% Au is deposited to a film thickness of 0.2 µm (specific resistance = 2.8 µΩ·cm) using the sputtering technique. The process is performed at room temperature.

Subsequently, an amorphous transparent conductive film composed mainly of indium oxide and zinc oxide is deposited using the sputtering technique. The target used for the sputtering process is a sintered body of In₂O₃-ZnO in which the atomic ratio of In/(In+Zn) has been adjusted to 0.83. This sintered body is mounted on the cathode of a planar magnetron sputtering apparatus so that it can serve as the target. Using a pure argon gas or an argon gas containing approximately 1vol% oxygen as the discharge gas, a film for transparent electrode 20b is deposited to a film thickness of 1200 angstroms. The X-ray diffraction analysis of the resulting In₂O₃-ZnO film showed no peaks, indicating that the film was amorphous.

To form a desired pattern for reflective pixel electrodes and output electrodes, the resulting film for transparent electrode 20b was subjected to an aqueous etching solution containing nitric acid, acetic acid, and phosphoric acid, which had had its concentration adjusted so that it could etch the Ag alloy layer and the indium oxide-zinc oxide layer at once.

A black matrix pattern is then formed to complete an α-SiTFT substrate 14. This TFT substrate 14 was used to make a TFT-LCD flat display. Video signals were provided to the display to confirm that the display had good performance.

### [Example 1-3]

This example is for reference and comprises a substrate for organic EL device in which an exemplary Ag alloy of the present invention is used in the wiring.

A conductive metal oxide film was deposited in the same manner as in Example 1-1. The film was deposited to a thickness of 300 angstroms using the sputtering technique with a target made of In₂O₃-ZnO. The atomic ratio of In/(In+Zn) had been adjusted to 0.83. Thus, this conductive metal oxide film corresponds to the transparent electrode described in Example 1-1.

Example 1-3 is characteristic in that the composition of the conductive metal oxide film contains Pd in an amount of 3 atomic % with respect to the total amount of metals. The work function of this conductive film was determined, by an atmospheric-ultraviolet photoelectron spectrometer (AC-1, Riken Keiki Co., Ltd.), to be 5.65 eV, indicating that the conductive film had desirable properties for use as an anode of an organic EL device.

While Pd was used in this example, Ru, Re, and Ir may also be used. When used, these metals gave work functions of 5.51 eV, 5.63 eV and 5.61 eV, respectively. Thus, each proved to have desirable properties for use as an anode of an organic EL device.

### 2. An embodiment of Cu alloy

In this embodiment, a Cu alloy is proposed to serve as a wiring material according to the present invention. This alloy contains Cu as the major component and shows good adhesion to glass substrates and silicon wafers.

In particular, one example is described in which such an alloy is produced by sputtering. First, we briefly describe the preparation of a target used in the sputtering process. At a predetermined ratio, Au and Co is mixed with Cu and melted in a vacuum smelting furnace. The melt is allowed to cool and harden and the hardened alloy is rolled into a plate, which in turn is cut and abraded to form a target measuring 4 inches in diameter. For sputtering, the target is mounted on a backing plate of a sputtering apparatus. By the time the sputtering process using this target is finished, a film has been deposited on a glass surface or a silicon wafer.

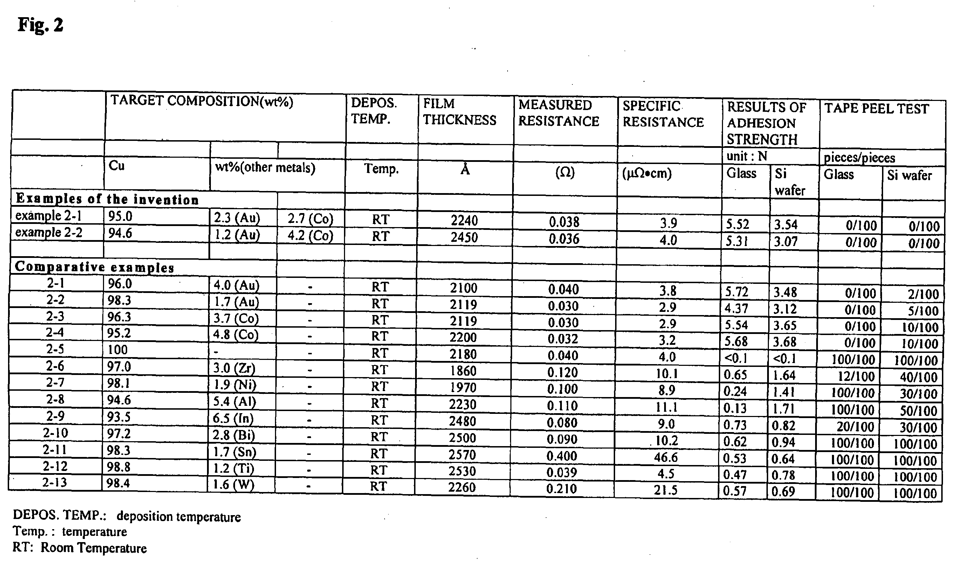

The performances of thin films having different compositions are compared with one another. The results of the comparison are shown in the table in Fig. 2. The table contains the compositions of the targets used, film thicknesses, measured resistances, specific resistances, adhesion strengths, the results of the tape peel test and other data. Each film was deposited at room temperature.

The composition of each film was determined by an X-ray microanalyzer (EPMA: Electron Probe Micro-analysis), and the conductivity (measured resistance and specific resistance) of each film was determined by the four probe technique.

The peel strength of each film was determined using a similar technique and conditions to those used in the above-described embodiment of Ag alloy.

Each film was tested in the tape peel test using a similar technique and conditions to those used in the above-described embodiment of Ag alloy. The table in Fig. 2 shows the number of 1mmx1mm tape pieces out of 100 that came off.

The scratch test and the tape peel test were performed according to standards defined by Japanese Industrial Standards (JIS).

### [Basic Examples]

The table in Fig. 2 shows total of two examples: examples in which the target was composed of Cu with Au and Co both added. In each example, one of the above-described alloys was used as the target that was subjected to sputtering to deposit a film on a glass substrate or a silicon wafer.

In Examples 2-1 and 2-2, the Cu target for forming the thin film contained Au and Co. Specifically, the target of Example 2-1 contained Au and Co in amounts of 2.3wt% and 2.7%, respectively. The target of Example 2-2 contained Au and Co in amounts of 1.2% and 4.2%, respectively.

In Example 2-1, the specific resistance was determined to be 3.9 µΩ·cm. The adhesion strength was 5.52 N for the glass substrate and 3.54 N for the silicon wafer. The results of the tape peel test indicate that no peeling was observed in the glass substrate or in the silicon wafer.

In Example 2-2, the specific resistance was determined to be 4.0 µΩ·cm. The adhesion strength was 5.31 N for the glass substrate and 3.07 N for the silicon wafer. The results of the tape peel test indicate that no peeling was observed in the glass substrate or in the silicon wafer.

### [Comparative Examples]

The table of Fig. 2 also contains Comparative Examples 2-1 through 2-13 for comparison with Basic Examples described above.

In Comparative Examples 2-1 and 2-2, the target for forming the thin film was composed of Cu with Au added. The targets of Comparative Examples 2-1 and 2-2 contained Au in amounts of 4.0wt% and 1.7%, respectively.

In Comparative Example 2-1, the specific resistance was determined to be 3.8 µΩ·cm. The adhesion strength was 5.72 N for the glass substrate and 3.48 N for the silicon wafer. The results of the tape peel test indicate that no peeling was observed for the glass substrate and only two out of 100 tape pieces came off the silicon wafer.

In Comparative Example 2-2, the specific resistance was determined to be 2.9 µΩ·cm. The adhesion strength was 4.37 N for the glass substrate and 3.12 N for the silicon wafer. The results of the tape peel test indicate that no peeling was observed for the glass substrate and only five out of 100 tape pieces came off the silicon wafer.

In Comparative Examples 2-3 and 2-4, the Cu target for forming the thin film contained Co. Specifically, the targets of Examples 2-3 and 2-4 contained Co in amounts of 3.7wt% and 4.8%, respectively.

In Example 2-3, the specific resistance was determined to be 2.9 µΩ·cm. The adhesion strength was 5.54 N for the glass substrate and 3.65 N for the silicon wafer. The results of the tape peel test indicate that no peeling was observed for the glass substrate and ten out of 100 tape pieces came off the silicon wafer.

In Example 2-4, the specific resistance was determined to be 3.2 µΩ·cm. The adhesion strength was 5.68 N for the glass substrate and 3.68 N for the silicon wafer. The results of the tape peel test indicate that no peeling was observed for the glass substrate and ten out of 100 tape pieces came off the silicon wafer.

Comparative Example 2-5 was composed only of Cu. In this Comparative Example 2-5, the specific resistance was determined to be 4.0 µΩ·cm. The adhesion strength was 0.1 N or less for each of the glass substrate and the silicon wafer. The results of the tape peel test indicate that all of the one hundred tape pieces came off in each of the glass substrate and the silicon wafer.

In Comparative Example 2-6, the Cu target for forming the thin film contained 3.0wt% Zr. In this Comparative Example 2-6, the specific resistance was determined to be 10.1 µΩ·cm. The adhesion strength was 0.65 N for the glass substrate and 1.64 N for the silicon wafer. The results of the tape peel test indicate that twelve out of 100 tape pieces came off the glass substrate and 40 pieces came off the silicon wafer.

In Comparative Example 2-7, the Cu target for forming the thin film contained 1.9wt% Ni. In this Comparative Example 2-7, the specific resistance was determined to be 8.9 µΩ·cm. The adhesion strength was 0.24 N for the glass substrate and 1.41 N for the silicon wafer. The results of the tape peel test indicate that all of the one hundred tape pieces came off the glass substrate and 30 pieces came off the silicon wafer.

In Comparative Example 2-8, the Cu target for forming the thin film contained 5.4wt% Al. In this Comparative Example 2-8, the specific resistance was determined to be 11.1 µΩ·cm. The adhesion strength was 0.13 N for the glass substrate and 1.71 N for the silicon wafer. The results of the tape peel test indicate that all of the one hundred tape pieces came off the glass substrate and 50 pieces came off the silicon wafer.

In Comparative Example 2-9, the Cu target for forming the thin film contained 6.5wt% In. In this Comparative Example 2-9, the specific resistance was determined to be 9.0 µΩ·cm. The adhesion strength was 0.73 N for the glass substrate and 0.82 N for the silicon wafer. The results of the tape peel test indicate that 20 out of 100 tape pieces came off the glass substrate and 30 pieces came off the silicon wafer.

In Comparative Example 2-10, the Cu target for forming the thin film contained 2.8wt% Bi. In this Comparative Example 2-10, the specific resistance was determined to be 10.2 µΩ·cm. The adhesion strength was 0.62 N for the glass substrate and 0.94 N for the silicon wafer. The results of the tape peel test indicate that all of the one hundred tape pieces came off in each of the glass substrate and the silicon wafer.

In Comparative Example 2-11, the Cu target for forming the thin film contained 1.7wt% Sn. In this Comparative Example 2-11, the specific resistance was determined to be 46.6 µΩ·cm. The adhesion strength was 0.53 N for the glass substrate and 0.64 N for the silicon wafer. The results of the tape peel test indicate that all of the one hundred tape pieces came off in each of the glass substrate and the silicon wafer.

In Comparative Example 2-12, the Cu target for forming the thin film contained 1.2wt% Ti. In this Comparative Example 2-12, the specific resistance was determined to be 4.5 µΩ·cm. The adhesion strength was 0.47 N for the glass substrate and 0.78 N for the silicon wafer. The results of the tape peel test indicate that all of the one hundred tape pieces came off in each of the glass substrate and the silicon wafer.

In Comparative Example 2-13, the Cu target for forming the thin film contained 1.6wt% W. In this Comparative Example 2-13, the specific resistance was determined to be 21.5 µΩ·cm. The adhesion strength was 0.57 N for the glass substrate and 0.69 N for the silicon wafer. The results of the tape peel test indicate that all of the one hundred tape pieces came off in each of the glass substrate and the silicon wafer.

### [Application Examples]

### [Application Example 2-1]

This example is for reference and comprises a transmissive TFT-LCD in which an exemplary Cu alloy of the present invention is used in the wiring. While the basic structure of transmissive TFT-LCD has already been described with reference to Figs. 3 to 5, various protective films/layers (not shown in Figs. 3 to 5) are formed in actual production processes.

First, a Cu alloy containing 2.3wt% Au and 2.7wt% Co is deposited on a transparent glass substrate 18b to a film thickness of 1500 angstroms (specific resistance = 3.9 µΩ·cm) by using the high frequency sputtering technique. The resulting film is subjected to a photo-etching process using an ammonium persulfate-based aqueous etching solution to form a gate electrode 34 and wirings for the gate electrode of desired shape.

Next, using the glow discharge CVD technique, a silicon nitride (SiNₓ) film to serve as the gate insulation film is deposited to a film thickness of 3000 angstroms. This is followed by the deposition of α-Si:H(i) film 38 to a film thickness of 3500 angstroms. As the discharge gas, an SiH₄-NH₃-N₂ gas and an SiH₄-N₂-based mixed gas are used for the deposition of the SiNₓ film 35 and the α-Si:H(i) film 38, respectively. The SiNₓ film 35 is subjected to dry etching using CF₄ gas to form a desired protective layer for the channels.

Using an SiH₄-H₂-PH₃-based mixed gas, an α-Si:H(n) film is then deposited to a film thickness of 3000 angstroms. Subsequently, a Cu alloy containing 1.2wt% Au and 4.2wt% Co is deposited over the α-Si:H(n) film to a film thickness of 0.3 µm (specific resistance = 4.0 µΩ·cm) using the sputtering technique. The process is performed at room temperature.

This layer is then subjected to a photo-etching process using an aqueous etching solution containing hydrochloric acid, potassium hydrogen peroxysulfate, and hydrofluoric acid to form a desired pattern of a source electrode 32 and a drain electrode 36. Subsequently, the α-Si:H(i) film 38 and the α-Si:H(n) film are each etched into a desired pattern using dry etching with CF₄ gas in conjunction with wet etching with an aqueous solution of hydrazine (NH₂NH₂·H₂O). Using the glow discharge CVD technique, a silicon nitride (SiNₓ) film to serve as the insulation film is then deposited thereover to a film thickness of 3000 angstroms. As the discharge gas, an SiH₄-NH₃-N₂ gas is used for the deposition of the SiNₓ film. The SiNₓ film is then subjected to a photo-etching process by dry etching using CF₄ gas to form an output port for the gate electrode 34, an output port for the source electrode 32, and a through hole 40b to provide electrical connection between the drain electrode 36 and the transparent electrode 20b. The Cu alloy electrode so obtained is then exposed to argon plasma to clean the surface.

Subsequently, an amorphous transparent conductive film composed mainly of indium oxide and zinc oxide is deposited using the sputtering technique. The target used for the sputtering process is a sintered body of In₂O₃-ZnO in which the atomic ratio of In/(In+Zn) has been adjusted to 0.83. This sintered body is mounted on the cathode of a planar magnetron sputtering apparatus so that it can serve as the target. Using a pure argon gas or an argon gas containing approximately 1vol% oxygen as the discharge gas, a film for transparent electrode 20b is deposited to a film thickness of 1200 angstroms. The X-ray diffraction analysis of the resulting In₂O₃-ZnO film showed no peaks, indicating that the film was amorphous.

The resulting film for transparent electrode 20b was subjected to a photo-etching process using a 3.4wt% aqueous solution of oxalic acid to form a desired pattern for pixel electrodes and output electrodes. A black matrix pattern is then formed to complete an α-SiTFT substrate 14. This TFT substrate 14 was used to make a TFT-LCD flat display. Video signals were provided to the display to confirm that the display had good performance.

### [Application Example 2-2]

This example comprises a reflective TFT-LCD in which an exemplary Cu alloy of the present invention is used in the wiring. The basic structure of reflective TFT-LCD is different from that of the transmissive TFT-LCD in that a light reflective electrode is used in place of the transparent electrode 20b on the TFT substrate 14 of the transmissive TFT-LCD. While not shown in Figs. 3 to 5, various protective films/layers are deposited in actual production processes. It is well known that reflective TFT-LCDs are different from transmissive TFT-LCDs in many ways, aside from the electrodes.

First, a Cu alloy containing 2.3wt% Au and 2.7wt% Co is deposited on a transparent glass substrate 18b to a film thickness of 1500 angstroms (specific resistance = 3.9 µΩ·cm) by using the high frequency sputtering technique. The resulting film is subjected to a photo-etching process using an ammonium persulfate-based aqueous etching solution to form a gate electrode 34 and wirings for the gate electrode of desired shape.

Next, using the glow discharge CVD technique, a silicon nitride (SiNₓ) film to serve as the gate insulation film is deposited to a film thickness of 3000 angstroms. This is followed by the deposition of α-Si:H(i) film 38 to a film thickness of 3500 angstroms. As the discharge gas, an SiH₄-NH₃-N₂ gas and an SiH₄-N₂-based mixed gas are used for the deposition of the SiNₓ film 35 and the α-Si:H(i) film 38, respectively. The SiNₓ film 35 is subjected to dry etching using CF₄ gas to form a desired protective layer for the channels.

Using an SiH₄-H₂-PH₃-based mixed gas, an α-Si:H(n) film is then deposited to a film thickness of 3000 angstroms. Subsequently, a Cu alloy containing 1.2wt% Au and 4.2wt% Co is deposited over the α-Si:H(n) film to a film thickness of 0.3 µm (specific resistance = 4.0 µΩ·cm) using the sputtering technique. The process is performed at room temperature.

This layer is then subjected to a photo-etching process using an aqueous etching solution containing hydrochloric acid, potassium hydrogen peroxysulfate, and hydrofluoric acid to form a desired pattern of a source electrode 32 and a drain electrode 36. Subsequently, the α-Si:H(i) film 38 and the α-Si:H(n) film are each etched into a desired pattern using dry etching with CF₄ gas in conjunction with wet etching with hydrazine (NH₂NH₂·H₂O). Using the glow discharge CVD technique, a silicon nitride (SiNₓ) film to serve as the insulation film is then deposited to a film thickness of 3000 angstroms. As the discharge gas, an SiH₄-NH₃-N₂ gas is used for the deposition of the SiNₓ film. The SiNₓ film is then subjected to a photo-etching process by dry etching using CF₄ gas to form an output port for the gate electrode 34, an output port for the source electrode 32, and a through hole 40b to provide electrical connection between the drain electrode 36 and the transparent electrode 20b. The Cu alloy electrode so obtained is then exposed to argon plasma to clean the surface.

Subsequently, a Cu alloy containing 2.3wt% Au and 2.7wt% Co is deposited to a film thickness of 0.2 µm (specific resistance = 3.9 Ω·cm) using the sputtering technique. The process is performed at room temperature.

An amorphous transparent conductive film composed mainly of indium oxide and zinc oxide is then deposited using the sputtering technique. The target used for the sputtering process is a sintered body of In₂O₃-ZnO in which the atomic ratio of In/(In+Zn) has been adjusted to 0.83. This sintered body is mounted on the cathode of a planar magnetron sputtering apparatus so that it can serve as the target. Using a pure argon gas or an argon gas containing approximately 1vol% oxygen as the discharge gas, a film for transparent electrode 20b is deposited to a film thickness of 300 angstroms. The X-ray diffraction analysis of the resulting In₂O₃-ZnO film showed no peaks, indicating that the film was amorphous.

To form a desired pattern for reflective pixel electrodes and output electrodes, the resulting film for transparent electrode 20b was subjected to a photo-etching process using an ammonium persulfate-based aqueous etching solution. This solution had had its concentration adjusted so that it could etch the Cu alloy layer and the indium oxide-zinc oxide layer at once.

A black matrix pattern is then formed to complete an α-SiTFT substrate 14. This TFT substrate 14 was used to make a TFT-LCD flat display. Video signals were provided to the display to confirm that the display had good performance.

### [Application Example 2-3]

This example is for reference and comprises a substrate for organic EL device in which an exemplary Cu alloy of the present invention is used in the wiring.

First, a Cu alloy containing 2.3wt% Au and 2.7wt% Co was deposited on a glass substrate to a film thickness of 1500 angstroms (specific resistance = 3.9 µΩ·cm).

A conductive metal oxide film was then deposited over the Cu alloy film. The film was deposited to a thickness of 300 angstroms using the sputtering technique with a target made of In₂O₃-ZnO. The atomic ratio of In/(In+Zn) had been adjusted to 0.83. Thus, this conductive metal oxide film corresponds to the transparent electrode described in Examples 2-1 and 2-2.

The present Application Example 2-3 is characteristic in that the composition of the conductive metal oxide film contains Pd in an amount of 3 atomic % with respect to the total amount of metals.

The work function of this conductive film was determined, by an atmospheric-ultraviolet photoelectron spectrometer (AC-1, Riken Keiki Co., Ltd.), to be 5.65 eV, indicating that the conductive film had desirable properties for use as an anode of an organic EL device.

While Pd was used in this example, Ru, Re, and Ir may also be used. When used, these metals gave work functions of 5.51 eV, 5.63 eV, and 5.61 eV, respectively. Thus, each proved to have desirable properties for use as an anode of an organic EL device.

As set forth, the present invention provides a wiring material that shows an improved adhesion strength to glass substrates and silicon wafers while offering a low resistance. Thus, when used in the wirings in TFT-LCDs, organic EL devices, or other electronic devices, the wiring material of the present invention prevents the peeling of the wirings and its low resistance helps improve properties of the devices.

The present invention, in which a particular Ag alloy or Cu alloy is sputtered to form a film to serve as a metal electrode, also makes it possible to minimize the number of production steps involved and enables the efficient production of TFT arrays. Thus, the invention allows low cost production of TFT-LCDs and TFT-driven organic EL devices. In particular, the present invention employs a particular composition that minimizes the occurrence of abnormal discharge during sputtering and thus enables efficient production of the devices.

## Claims

1. A wiring material comprising an Ag alloy which comprises Ag and Zr as major components and at least one metal selected from the group consisting of Au, Ni, Co, and Al;
wherein said Ag alloy comprises
60 to 99 wt % of Ag;
1 to 5 wt % of Zr;
0 to 20 wt % of Au;
0 to 20 wet % of Ni;
0 to 20 wt % of Co; and
0 to 39 wt % of Al.

2. The wiring material according to claim 1, further containing 0 to 1 wt % of at least one metal selected from the group consisting of Re, Ru, Pd, and Ir.

3. The wiring material formed of the Ag alloy according to claim 1 or 2, having a specific resistance of 4 µΩ·cm or less.

4. A wiring board comprising:
a substrate; and
a wiring composed of the wiring material according to any one of claims 1 to 3.

5. The wiring board according to claim 4, wherein the substrate is a glass substrate or a silicon substrate.

6. The wiring board according to claim 4 or 5, wherein the adhesion strength of the wiring to the substrate as determined by the scratch method is 3 N or higher.

7. The wiring board according to any one of claims4 to 6 which is a wiring board for a semiconductor device, wherein the wiring comprises a gate wiring and a gate electrode of a thin film transistor formed on the wiring board.

8. The wiring board according to any one of claims4 to 6 which is a wiring board for a semiconductor device, wherein the wiring comprises a source wiring and a drain wiring, and a source electrode and a drain electrode, of a thin film transistor formed on the wiring board.

9. The wiring board according to any one of claims 4 to 8, wherein the substrate is non-conductive at least on its surface; and a conductive metal oxide layer is deposited over the wiring.

10. The wiring board according to claim 9, wherein the wiring and the conductive metal oxide film form a stacked wiring of a two-layered structure.

11. The wiring board according to claim 9 or 10, wherein the conductive metal oxide film comprises an amorphous transparent conductive film that is formed of indium oxide and zinc oxide and has an atomic composition such that the following relationship holds: In/(In+Zn) = 0.8 to 0.95.

12. The wiring board according to any one of claims 9 to 11, wherein the amorphous transparent conductive film has a work function of 5.4 eV or larger.

13. A wiring material, comprising a Cu alloy composed of Au and Co, and Cu, wherein the Cu alloy contains Cu in an amount of 80 to 99.5 wt % and Au and Co in a total amount of 0.5 to 20 wt %.

14. The wiring material according to claim 13, wherein the amount of Au is up to 10 wt %.

15. The wiring material according to claim 13, wherein the amount of Co is up to 10 wt %.

16. A wiring material comprising the Cu alloy according to any one of claims 13 to 15, having a specific resistance of 4 µΩ·cm or less.

17. A wiring board, comprising:
a wiring formed of the wiring material according to any one of claims 13 to 16;
a conductive metal oxide film; and
a substrate.

18. The wiring board according to claim 17, wherein the wiring and the conductive metal oxide film form a stacked wiring of a two-layered structure.

19. The wiring board according to claim 16 or 17, wherein the conductive metal oxide film contains 0.05 atomic % to 5 atomic % of at least one metal selected from the group consisting of Ru, Pd, Re, and Ir.

20. The wiring board according to any one of claims 17 to 19, wherein the conductive metal oxide film comprises an amorphous transparent conductive film that is formed of indium oxide and zinc oxide and has an atomic composition such that the following relationship holds: In/(In+Zn) = 0.8 to 0.95.

21. The wiring board according to any one of claims 17 to 20, comprising the substrate with a non-conductive surface.

22. A wiring board, comprising:
a substrate;
a wiring disposed on the substrate and formed of the wiring material according to any one of claims 13 to 16; and
a thin film transistor.

## Patentansprüche

1. Verdrahtungsmaterial, umfassend ein Ag-Legierung, welche Ag und Zr als Hauptkomponenten und mindestens ein Metall umfasst, das ausgewählt wird aus der aus Au, Ni, Co und Al bestehenden Gruppe; wobei die Ag-Legierung umfasst
60 bis 99 Gew.-% Ag;
1 bis 5 Gew.-% Zr;
0 bis 20 Gew.-% Au;
0 bis 20 Gew.-% Ni;
0 bis 20 Gew.-% Co; und
0 bis 39 Gew.-% Al.

2. Verdrahtungsmaterial nach Anspruch 1 , darüber hinaus enthaltend 0 bis 1 Gew.-% mindestens eines Metalls, das ausgewählt wird aus der aus Re, Ru, Pd und Ir bestehenden Gruppe.

3. Verdrahtungsmaterial, welches aus der Ag-Legierung nach Anspruch 1 oder 2 gebildet ist und einen spezifischen Widerstand von 4 µΩ·cm oder weniger aufweist.

4. Leiterplatte, umfassend:
ein Substrat; und
eine Verdrahtung, aufgebaut aus dem Verdrahtungsmaterial nach einem der Ansprüche 1 bis 3.

5. Leiterplatte nach Anspruch 4, wobei das Substrat ein Glassubstrat oder ein Siliziumsubstrat ist.

6. Leiterplatte nach Anspruch 4 oder 5, wobei die Adhäsionskraft der Verdrahtung mit dem Substrat, bestimmt durch die Kratz-Methode, 3 N oder höher ist.

7. Leiterplatte nach einem der Ansprüche 4 bis 6, welche eine Leiterplatte für eine Halbleitervorrichtung ist, wobei die Verdrahtung eine Gate-Verdrahtung und eine Gate-Elektrode aus einem Dünnschicht-Transistor umfasst, der auf der Leiterplatte ausgebildet ist.

8. Leiterplatte nach einem der Ansprüche 4 bis 6, welche eine Leiterplatte für eine Halbleitervorrichtung ist, wobei die Verdrahtung eine Source-Verdrahtung und eine Drain-Verdrahtung und eine Source-Elektrode und eine Drain-Elektrode aus einem Dünnschicht-Transistor umfasst, die auf der Leiterplatte ausgebildet sind.

9. Leiterplatte nach einem der Ansprüche 4 bis 8, wobei das Substrat mindestens an seiner Oberfläche nicht leitfähig ist; und eine leitfähige Metalloxidschicht über der Verdrahtung abgeschieden ist.

10. Leiterplatte nach Anspruch 9, wobei die Verdrahtung und der leitfähige Metalloxidfilm eine aufeinandergestapelte Verdrahtung mit einer zweischichtigen Struktur bilden.

11. Leiterplatte nach Anspruch 9 oder 10, wobei der leitfähige Metalloxidfilm einen amorphen transparenten Leitfilm umfasst, der aus Indiumoxid und Zinkoxid gebildet ist und eine Atomzusammensetzung der Art aufweist, dass die folgende Beziehung gilt: In/(In+Zn)=0,8 bis 0,95.

12. Leiterplatte nach einem der Ansprüche 9 bis 1 1 , wobei der amorphe transparente leitfähige Film eine Austrittsarbeit von 5,4 eV oder größer aufweist.

13. Verdrahtungsmaterial, umfassend eine Cu-Legierung, die aus Au und Co und Cu aufgebaut ist, wobei die Cu-Legierung Cu in einer Menge von 80 bis 99,5 Gew.-% und Au und Co in einer Gesamtmenge von 0,5 bis 20 Gew.-% enthält.

14. Verdrahtungsmaterial nach Anspruch 13, wobei die Menge an Au bis zu 1 0 Gew. % beträgt.

15. Verdrahtungsmaterial nach Anspruch 13, wobei die Menge an Co bis zu 10 Gew.-% beträgt.

16. Verdrahtungsmaterial, umfassend die Cu-Legierung nach einem der Ansprüche 13 bis 15, welche einen spezifischen Widerstand von 4 µΩ·cm oder weniger aufweist.

17. Leiterplatte, umfassend.
eine Verdrahtung, die aus dem Verdrahtungsmaterial auf einem der Ansprüche 13 bis 16 gebildet ist;
einen leitfähigen Metalloxidfilm; und
ein Substrat.

18. Leiterplatte nach Anspruch 17, wobei die Verdrahtung und der leitfähige Metalloxidfilm eine aufeinandergestapelte Verdrahtung aus einer zweischichtigen Struktur bilden.

19. Leiterplatte nach Anspruch 16 oder 17, wobei der leitfähige Metalloxidfilm 0,05 Atom-% bis 5 Atom-% mindestens eines Metalls enthält, das ausgewählt wird aus der aus Ru, Pd, Re und Ir bestehenden Gruppe.

20. Leiterplatte nach einem der Ansprüche 17 bis 19, wobei der leitfähige Metalloxidfilm einen amorphen transparenten leitfähigen Film umfasst, der aus Indiumoxid und Zinkoxid gebildet ist und eine Atomzusammensetzung der Art aufweist, dass die folgende Beziehung gilt: In/(In+Zn)=0,8 bis 0,95.

21. Leiterplatte nach einem der Ansprüche 17 bis 20, umfassend das Substrat mit einer nicht-leitfähigen Oberfläche.

22. Leiterplatte, umfassend:
ein Substrat;
eine auf dem Substrat vorgesehene Verdrahtung, die aus dem Verdrahtungsmaterial nach einem der Ansprüche 13 bis 16 gebildet ist; und
einen Dünnschichttransistor.

## Revendications

1. Matière de câblage, comprenant un alliage d'Ag qui comprend Ag et Zr, en tant que composants principaux, et au moins un métal choisi parmi le groupe consistant en Au, Ni, Co et Al; dans lequel ledit alliage d'Ag comprend :
de 60 à 99 % d'Ag ;
de 1 à 5 % de Zr ;
de 0 à 20 % d'Au ;
de 0 à 20 % de Ni ;
de 0 à 20 % de Co ; et
de 0 à 39 % d'Al.

2. La matière de câblage selon la revendication 1, contenant, en outre, de 0 à 1 % en poids d'au moins un métal choisi parmi le groupe consistant en Re, Ru, Pd et Ir.

3. La matière de câblage formée de l'alliage d'Ag selon la revendication 1 ou 2, ayant une résistance spécifique de 4 µΩ·cm ou moins.

4. Plaque à câblage, comprenant :
un substrat ; et
un câblage composé de la matière de câblage selon l'une quelconque des revendications 1 à 3.

5. La plaque à câblage selon la revendication 4, dans laquelle le substrat est un substrat de verre ou un substrat de silicium.

6. La plaque à câblage selon la revendication 4 ou 5, dans laquelle la résistance d'adhérence du câblage au substrat, déterminée par le procédé à la rayure, est de 3 N ou plus.

7. La plaque à câblage selon l'une quelconque des revendications 4 à 6, qui est une plaque à câblage pour un dispositif à semi-conducteur, dans laquelle le câblage comprend un câblage de grille et une électrode de grille d'un transistor à film mince formé sur la plaque à câblage.

8. La plaque à câblage selon l'une quelconque des revendications 4 à 6, qui est une plaque à câblage pour un dispositif à semi-conducteur, dans laquelle le câblage comprend un câblage de source et un câblage de drain, et une électrode de source et une électrode de drain, d'un transistor à film mince formé sur la plaque à câblage.

9. La plaque à câblage selon l'une quelconque des revendications 4 à 8, dans laquelle le substrat est non conducteur au moins sur sa surface ; et une couche d'oxyde de métal conducteur est déposée sur le câblage.

10. La plaque à câblage selon la revendication 9, dans laquelle le câblage et le film d'oxyde de métal conducteur forment un câblage stratifié à structure à deux couches.

11. La plaque à câblage selon la revendication 9 ou 10, dans laquelle le film d'oxyde de métal conducteur comprend un film conducteur amorphe transparent, qui est formé d'oxyde d'indium et d'oxyde de zinc, et a une composition atomique telle que la relation suivante est maintenue : In/(In + Zn) = 0,8 à 0,95.

12. La plaque à câblage selon l'une quelconque des revendications 9 à 11, dans laquelle le film conducteur amorphe transparent a un travail de sortie de 5,4 eV ou plus.

13. Matière de câblage, comprenant un alliage de Cu composé d'Au et Co, et de Cu, dans laquelle l'alliage de Cu contient une quantité de 80 à 99,5 % en poids, et Au et Co en une quantité totale de 0,5 à 20 % en poids.

14. La matière de câblage selon la revendication 13, dans laquelle la quantité d'Au varie jusqu'à 10 % en poids.

15. La matière de câblage selon la revendication 13, dans laquelle la quantité de Co varie jusqu'à 10 % en poids.

16. Matière de câblage, comprenant l'alliage de Cu selon l'une quelconque des revendications 13 à 15, ayant une résistance spécifique de 4 µΩ.cm ou moins.

17. Plaque à câblage, comprenant :
un câblage formé de la matière de câblage selon l'une quelconque des revendications 13 à 16 ;
un film d'oxyde de métal conducteur ; et
un substrat.

18. La plaque à câblage selon la revendication 17, dans laquelle le câblage et le film d'oxyde de métal conducteur forment un câblage stratifié à structure à deux couches.

19. La plaque à câblage selon la revendication 16 ou 17, dans laquelle le film d'oxyde de métal conducteur contient de 0.05 atome % à 5 atomes % d'au moins un métal choisi parmi le groupe consistant en Ru, Pd, Re et Ir.

20. La plaque à câblage selon l'une quelconque des revendications 17 à 19, dans laquelle le film d'oxyde de métal conducteur comprend un film conducteur amorphe transparent, qui est formé d'oxyde d'indium et d'oxyde de zinc, et a une composition atomique telle que la relation suivante est maintenue : In/(In + Zn) = 0,8 à 0,95.

21. La plaque à câblage selon l'une quelconque des revendications 17 à 20, comprenant le substrat avec une surface non conductrice.

22. Plaque à câblage, comprenant :
un substrat ;
un câblage placé sur le substrat, et formé de la matière de câblage selon l'une quelconque des revendications 13 à 16 ; et
un transistor à film mince.
